(19) **Europäisches Patentamt / European Patent Office / Office européen des brevets**

(11) **EP 3 913 433 B1**

(12) **FASCICULE DE BREVET EUROPEEN**

(45) Date de publication et mention
de la délivrance du brevet:
**30.11.2022 Bulletin 2022/48**

(21) Numéro de dépôt: **21174122.8**

(22) Date de dépôt: **17.05.2021**

(51) Classification Internationale des Brevets (IPC):
**G03F 7/00** *(2006.01)* **G06N 3/063** *(2006.01)*
**G06N 3/04** *(2006.01)*

(52) Classification Coopérative des Brevets (CPC):
**G03F 7/0002; G06N 3/0445; G06N 3/063**

(54) **PROCÉDÉ DE FABRICATION DE MOULES POUR LITHOGRAPHIE PAR NANO-IMPRESSION ET PROCÉDÉ DE FABRICATION D'UN CALCULATEUR À RÉSEAUX DE NEURONES RÉCURRENTS**

VERFAHREN ZUR HERSTELLUNG VON FORMEN FÜR DIE NANOPRÄGELITHOGRAPHIE UND HERSTELLUNGSVERFAHREN EINES RECHNERS MIT REKURRENTEN NEURONALEN NETZEN

METHOD FOR MANUFACTURING MOULDS FOR NANOIMPRINT LITHOGRAPHY AND METHOD FOR MANUFACTURING A COMPUTER WITH RECURRENT NEURAL NETWORKS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **19.05.2020 FR 2005118**

(43) Date de publication de la demande:
**24.11.2021 Bulletin 2021/47**

(73) Titulaire: **Commissariat à l'énergie atomique et aux énergies alternatives**
**75015 Paris (FR)**

(72) Inventeurs:
• **TIRON, Raluca**
**38054 GRENOBLE Cedex 09 (FR)**
• **CHAMIOT-MAITRAL, Gaëlle**
**38054 GRENOBLE Cedex 09 (FR)**
• **VIANELLO, Elisa**
**38054 GRENOBLE Cedex 09 (FR)**

(74) Mandataire: **INNOV-GROUP**
**310, avenue Berthelot**
**69372 Lyon Cedex 08 (FR)**

(56) Documents cités:
EP-A1- 3 579 151      FR-A1- 3 074 180
JP-A- 2014 066 976    US-A1- 2017 054 112
US-A1- 2020 012 018

• WU W ET AL: "One-kilobit cross-bar molecular memory circuits at 30-nm half-pitch fabricated by nanoimprint lithography", APPLIED PHYSICS A MATERIALS SCIENCE & PROCESSING, SPRINGER BERLIN HEIDELBERG, BERLIN/HEIDELBERG, vol. 80, no. 6, 1 mars 2005 (2005-03-01), pages 1173-1178, XP036005914, ISSN: 0947-8396, DOI: 10.1007/S00339-004-3176-Y [extrait le 2005-03-01]

## Description

### Domaine technique

L'invention se rapporte au domaine technique de la fabrication de moules pour lithographie par nano-impression.

L'invention trouve notamment son application dans la fabrication d'un calculateur à réseaux de neurones récurrents.

Les réseaux de neurones récurrents sont des réseaux de neurones artificiels où les connexions entre les unités forment au moins un cycle au sens de la théorie des graphes. Plus précisément, une application visée concerne les réseaux de neurones récurrents entraînés par le paradigme « *Reservoir computing* ». Ce paradigme est un système dynamique hautement non-linéaire, comportant :

- une couche d'entrée ;
- une couche cachée, appelée réservoir, munie de connexions récurrentes fixées de manière aléatoire ;
- une couche de sortie (« *readout* » en langue anglaise).

Le principe de ce paradigme est de projeter la couche d'entrée vers le réservoir, puis de modifier les connexions allant du réservoir vers la couche de sortie par un apprentissage supervisé.

En d'autres termes, une application visée concerne un calculateur qui est une implémentation physique ou matérielle (« *hardware* » en langue anglaise) du paradigme « *Reservoir computing* ». Un tel calculateur permet notamment la classification de tâches, l'extraction de caractéristiques, la poursuite d'objets (« *tracking* » en langue anglaise), la prédiction de mouvements en robotique, la reconnaissance vocale et la reconnaissance sonore.

### Etat de la technique antérieure

Un procédé de fabrication d'un calculateur à réseaux de neurones récurrents, connu de l'état de la technique, notamment du document « Atomic switch networks - nanoarchitectonic design of a complex system for natural computing », E.C. Demis et al., Nanotechnology, 26, 204003, 2015, comporte une étape de croissance aléatoire de nanofils d'argent sur une électrode structurée de platine. Le caractère aléatoire est obtenu par une étape préalable de formation de microsphères de cuivre sur l'électrode structurée. Les microsphères de cuivre forment une couche germe pour les nanofils d'argent. Le procédé comporte une étape de sulfuration des nanofils d'argent de manière à obtenir des structures du type Ag/$Ag_2$S/Ag. De telles structures forment des cellules de mémoire résistive de type interrupteur atomique.

Un tel procédé de l'état de la technique permet la fabrication d'un calculateur qui est une implémentation physique du paradigme « *Reservoir computing* ». Toutefois, un tel procédé de l'état de la technique n'est pas entièrement satisfaisant dans la mesure où le choix des matériaux pour la mémoire résistive est restreint. En effet, il est nécessaire de choisir un couple de matériaux compatible, de type conducteur électrique/diélectrique, pour la formation des nanofils et des cellules de mémoire résistive, en l'espèce Ag/$Ag_2$S.

Il est recherché une structure de type première électrode/couche mémoire/deuxième électrode, autorisant une liberté sur le choix du matériau de la couche mémoire, et introduisant un caractère aléatoire nécessaire dans le paradigme « *Reservoir Computing* », c'est-à-dire par exemple :

- des connexions récurrentes fixées de manière aléatoire dans le réservoir ;
- un nombre stochastique d'unités (une unité correspondant à une cellule de mémoire résistive, située à une intersection entre les première et deuxième électrodes) ;
- un temps de latence aléatoire entre les unités (e.g. une distance aléatoire entre les unités) ;
- un poids aléatoire des unités par une conductance aléatoire des cellules de la mémoire résistive (les cellules de la mémoire résistive étant formées par les zones d'intersection entre la couche mémoire et les première et deuxième électrodes).

La demande de brevet EP 3 579 151 A divulgue également un procédé de fabrication d'un calculateur à réseaux de neurones récurrents, mais préconise toutefois de ne pas utiliser de moule d'impression. Les demandes de brevet JP2014066976A, US2020/012018A et FR3074180A qui, par contre, ont trait à la fabrication par une technique d'auto-assemblage d'un moule d'impression comportant des motifs aléatoires, ne divulguent pas un jeu de moules d'impression permettant d'obtenir un calculateur à réseaux de neurones récurrents à motifs croisés. Finalement, un procédé de fabrication d'une mémoire cross-bar, utilisant deux fois un même moule d'impression en lui appliquant une rotation de 90 degrés entre deux étapes d'impression, est connu de l'état de la technique, notamment du document "One-kilobit cross-bar molecular memory circuits at 30-nm half-pitch fabricated by nanoimprint lithography", Wu W. et al., Appl. Phys. A 80, 1173-1178(2005).

### Exposé de l'invention

L'invention vise à remédier en tout ou partie aux inconvénients précités. A cet effet, l'invention a pour objet un procédé de fabrication de premier et second moules pour lithographie par nano-impression, comportant les étapes :

a) prévoir un substrat comprenant une première couche de neutralisation ;

b) former une couche d'un premier copolymère à blocs sur la première couche de neutralisation par une technique d'auto-assemblage, le premier copolymère à blocs comprenant des premier et deuxième monomères, la première couche de neutralisation possédant une affinité identique pour chacun des premier et deuxième monomères ; puis retirer sélectivement le deuxième monomère de sorte que la couche du premier copolymère à blocs comporte une série de premiers motifs lithographiques à structure aléatoire s'étendant suivant une première direction, chacun des premiers motifs lithographiques étant réalisé dans le premier monomère ;

c) créer un premier moule comportant des empreintes formées à partir de la série de premiers motifs lithographiques ;

d) prévoir une couche structurée comportant une série de motifs, conforme à la série de premiers motifs lithographiques, et s'étendant suivant la première direction, puis revêtir la couche structurée d'une seconde couche de neutralisation ;

e) former une couche d'un deuxième copolymère à blocs sur la seconde couche de neutralisation par une technique d'auto-assemblage, le deuxième copolymère à blocs comprenant des troisième et quatrième monomères, la seconde couche de neutralisation possédant une affinité identique pour chacun des troisième et quatrième monomères ; puis retirer sélectivement le quatrième monomère de sorte que la couche du deuxième copolymère à blocs comporte une série de seconds motifs lithographiques à structure aléatoire s'étendant suivant une seconde direction perpendiculaire à la première direction, chacun des seconds motifs lithographiques étant réalisé dans le troisième monomère ;

f) créer un second moule comportant des empreintes formées à partir de la série de seconds motifs lithographiques.

Ainsi, de tels premier et second moules fabriqués permettent de structurer une résine avec un caractère aléatoire issu de l'auto-assemblage des copolymères à blocs. Il est donc rendu possible la formation de première et deuxième électrodes par une technique de lithographie par nano-impression NIL (acronyme pour « *NanoImprint Lithography* » en langue anglaise), structurées respectivement grâce aux premier et second moules. En outre, le fait que la série de seconds motifs lithographiques est perpendiculaire à la série de premiers motifs lithographiques permet de maximiser le nombre d'intersections aléatoires (en projections transverses) entre les première et deuxième électrodes, et par là-même de maximiser la densité de cellules de mémoire résistive, chaque cellule étant située à une intersection entre les première et deuxième électrodes.

Par ailleurs, la couche mémoire du calculateur pourra être formée indépendamment des première et deuxième électrodes, ce qui autorise une liberté sur le choix du matériau de la couche mémoire.

## Définitions

- Par « substrat », on entend un support physique autoporté, classiquement une tranche (« *wafer* » en langue anglaise) découpée dans un lingot cristallin de matériau semi-conducteur.
- Par « couche de neutralisation », on entend une couche réalisée dans un matériau (e.g. un polymère) ne présentant pas d'interaction préférentielle avec l'un des blocs/monomères composant les copolymères à blocs. La première couche de neutralisation ne présente donc pas d'interaction préférentielle avec les premier ou deuxième monomères du premier copolymère à blocs. La seconde couche de neutralisation ne présente donc pas d'interaction préférentielle avec les troisième ou quatrième monomères du deuxième copolymère à blocs. La première couche de neutralisation permet de neutraliser les énergies interfaciales entre le substrat et la couche du premier copolymère à blocs. En d'autres termes, la première couche de neutralisation est une couche de fonctionnalisation permettant de contrôler les énergies de surface du substrat. La seconde couche de neutralisation permet de neutraliser les énergies interfaciales entre la couche structurée et la couche du deuxième copolymère à blocs. En d'autres termes, la seconde couche de neutralisation est une couche de fonctionnalisation permettant de contrôler les énergies de surface de la couche structurée.
- Par « couche structurée », on entend une couche présentant une surface discontinue délimitant un ensemble de motifs.
- Par « conforme à la série de premiers motifs lithographiques », on entend que la série de motifs de la couche structurée conserve la périodicité de la série de premiers motifs lithographiques.

Le procédé selon l'invention peut comporter une ou plusieurs des caractéristiques suivantes.

Selon une caractéristique de l'invention, le substrat prévu lors de l'étape a) est revêtu d'une couche d'oxyde, de préférence réalisée en $SiO_2$, sur laquelle est formée la première couche de neutralisation ; et l'étape c) est précédée d'une étape $c_0$) consistant à graver la première couche de neutralisation et la couche d'oxyde à travers la série de premiers motifs lithographiques.

Ainsi, un avantage procuré par la couche d'oxyde gravée est d'améliorer la qualité du premier moule créé lors de l'étape c), en réduisant sa défectivité. En outre, les copolymères à blocs possèdent la propriété de s'auto-assembler en réseaux denses d'objets nanométriques avec la capacité de former un masque de lithographie, ce qui permet de graver aisément la couche d'oxyde à travers la série de premiers motifs lithographiques.

Selon une caractéristique de l'invention, la couche structurée prévue lors de l'étape d) présente une épaisseur comprise entre 5 nm et 15 nm.

Ainsi, un avantage procuré par une telle épaisseur est d'obtenir une topologie de surface de la couche structurée favorable à l'efficacité de la technique d'auto-assemblage exécutée lors de l'étape e).

Selon une caractéristique de l'invention, l'étape d) comporte les étapes :

$d_0$) prévoir une couche, destinée à être structurée, sur un substrat support ;
$d_1$) déposer une résine thermoplastique sur la couche ;
$d_2$) appliquer les empreintes du premier moule créé lors de l'étape c) sur la résine thermoplastique, à une température adaptée pour mettre en forme la résine thermoplastique ;
$d_3$) solidifier la résine thermoplastique mise en forme lors de l'étape $d_2$), de manière à obtenir un masque de lithographie ;
$d_4$) graver la couche à travers le masque de lithographie obtenu lors de l'étape $d_3$), de manière à structurer la couche.

Ainsi, un avantage procuré est de pouvoir obtenir aisément par NIL, à l'aide du premier moule créé lors de l'étape c), une couche structurée comportant une série de motifs, conforme à la série de premiers motifs lithographiques, et s'étendant suivant la première direction.

Selon une caractéristique de l'invention, l'étape d) comporte les étapes :

$D_0$) prévoir une couche, destinée à être structurée, intercalée entre le substrat et la couche d'oxyde ;
$D_1$) éliminer la série de premiers motifs lithographiques et la première couche de neutralisation, l'étape $D_1$) étant exécutée après l'étape $c_0$) de sorte que la couche d'oxyde gravée lors de l'étape $c_0$) forme un masque de lithographie ;
$D_2$) graver la couche à travers le masque de lithographie formé lors de l'étape $D_1$), de manière à structurer la couche ;
D3) retirer la couche d'oxyde.

Ainsi, un avantage procuré est de pouvoir enchaîner la création du second moule à partir du même substrat prévu lors de l'étape a).

Selon une caractéristique de l'invention, la couche prévue lors de l'étape $D_0$) est réalisée dans un matériau choisi pour autoriser une gravure sélective de la couche d'oxyde, le matériau étant de préférence le TiN.

Par « autoriser une gravure sélective », on entend que la couche d'oxyde peut être gravée sans attaquer la couche prévue lors de l'étape $D_0$). En pratique, on choisira un agent de gravure de sorte que la vitesse de gravure de l'oxyde est au moins dix fois supérieure à celle du matériau de la couche prévue lors de l'étape $D_0$).

Ainsi, un avantage procuré est de pouvoir aisément retirer la couche d'oxyde sans dégrader la couche prévue lors de l'étape $D_0$).

Selon une caractéristique de l'invention, les premier et deuxième copolymères à blocs sont sélectionnés parmi :

- le polystyrène et le polyméthacrylate de méthyle, noté PS-PMMA ;
- le polystyrène et l'acide polylactique, noté PS-PLA ;
- le polystyrène et le poly(oxyde d'éthylène), noté PS-PEO ;
- le polystyrène et le polydiméthylsiloxane, noté PS-PDMS ;
- le polystyrène, le polyméthacrylate de méthyle, et le poly(oxyde d'éthylène), noté PS-PMMA-PEO ;
- le polystyrène et le poly(2-vinyl pyridine), noté PS-P2VP.

L'invention a également pour objet un procédé de fabrication d'un calculateur à réseaux de neurones récurrents, comportant les étapes successives :

a') prévoir un substrat comportant une première électrode ;
$b'_1$) déposer une résine thermoplastique sur la première électrode ;
$b'_2$) appliquer les empreintes du premier moule, fabriqué par un procédé conforme à l'invention, sur la résine thermoplastique, à une température adaptée pour mettre en forme la résine thermoplastique ;
$b'_3$) solidifier la résine thermoplastique mise en forme lors de l'étape $b'_2$), de manière à obtenir un masque de lithographie ;
$b'_4$) graver la première électrode à travers le masque de lithographie obtenu lors de l'étape $b'_3$), de manière à structurer la première électrode ;
$b'_5$) retirer la résine thermoplastique ;
c') former une couche mémoire, de type mémoire résistive, sur la première électrode structurée lors de l'étape $b'_4$) ;
d') former une deuxième électrode sur la couche mémoire ;
$e'_1$) déposer une résine thermoplastique sur la deuxième électrode ;
$e'_2$) appliquer les empreintes du second moule, fabriqué par un procédé conforme à l'invention, sur la résine thermoplastique, à une température adaptée pour mettre en forme la résine thermoplastique ;
$e'_3$) solidifier la résine thermoplastique mise en forme lors de l'étape $e'_2$), de manière à obtenir un masque de lithographie ;
$e'_4$) graver la deuxième électrode à travers le masque de lithographie obtenu lors de l'étape $e'_3$), de manière à structurer la deuxième électrode ;
$e'_5$) retirer la résine thermoplastique.

Ainsi, un tel procédé selon l'invention permet de structurer de manière aléatoire des première et deuxième électrodes par une technique de lithographie par nano-impression NIL (acronyme pour « *NanoImprint Lithography* » en langue anglaise), respectivement grâce aux premier et second moules. Le fait que les empreintes du premier moule sont perpendiculaires aux empreintes du second moule permet de maximiser le nombre d'intersections aléatoires (en projections transverses) entre les première et deuxième électrodes, et par là-même de maximiser la densité de cellules de mémoire résistive, chaque cellule étant située à une intersection entre les première et deuxième électrodes.

Par ailleurs, la couche mémoire du calculateur est formée indépendamment des première et deuxième électrodes, ce qui autorise une liberté sur le choix du matériau de la couche mémoire.

## Définitions

- Par « couche mémoire », on entend une couche ou une pluralité de sous-couches (par exemple réalisée(s) dans un matériau de type oxyde ou de type chalcogénure) formant, avec les première et deuxième électrodes, une mémoire résistive (ReRam « *Resistive random-access memory* » en langue anglaise). Plus précisément, les cellules de la mémoire résistive sont situées aux intersections entre les première et deuxième électrodes.

Le procédé selon l'invention peut comporter une ou plusieurs des caractéristiques suivantes.

Selon une caractéristique de l'invention, la couche mémoire formée lors de l'étape c') est réalisée dans au moins un matériau sélectionné parmi $HfO_2$, $Al_2O_3$, $SiO_2$, ZrO, un oxyde de titane, un chalcogénure, $Ta_2O_5$.

Selon une caractéristique de l'invention, les première et deuxième électrodes sont réalisées dans au moins un matériau sélectionné parmi Ti, TiN, Pt, Zr, Al, Hf, Ta, TaN, C, Cu, Ag.

Selon une caractéristique de l'invention, le procédé comporte une étape f) consistant à former une couche d'encapsulation sur la deuxième électrode structurée lors de l'étape e'$_4$), l'étape f) étant exécutée après l'étape e'$_5$).

Ainsi, un avantage procuré est de protéger le calculateur de l'air et de l'humidité.

Selon une caractéristique de l'invention, la première électrode structurée lors de l'étape b'$_4$) présente un pas, noté p, et dans lequel l'étape c') est exécutée de sorte que la couche mémoire présente une épaisseur, notée E, vérifiant :

$$p/2 \leq E \leq p.$$

Ainsi, une telle épaisseur E de la couche mémoire permet d'obtenir une topologie de surface quasi-plane de manière à faciliter la formation de la deuxième électrode lors de l'étape d'), tout en s'affranchissant d'une étape de polissage mécano-chimique.

L'invention a également pour objet un calculateur à réseaux de neurones récurrents, obtenu par un procédé conforme à l'invention.

## Brève description des dessins

D'autres caractéristiques et avantages apparaîtront dans l'exposé détaillé de différents modes de réalisation de l'invention, l'exposé étant assorti d'exemples et de références aux dessins joints.

Figure 1 est une vue schématique en coupe illustrant une étape d'un procédé de fabrication d'un premier moule selon l'invention.

Figure 2a est une vue schématique en perspective illustrant une étape d'un procédé de fabrication d'un premier moule selon l'invention.

Figure 2b, associée à la figure 2a, est une vue schématique partielle de dessus illustrant la morphologie de la couche du premier copolymère à blocs.

Figure 3 et Figure 4 sont des vues schématiques en coupe illustrant des étapes d'un procédé de fabrication d'un premier moule selon l'invention.

Figure 5a est une vue schématique en perspective d'un premier moule créé par un procédé selon l'invention.

Figure 5b, associée à la figure 5a, est une vue schématique partielle illustrant les empreintes du premier moule créé.

Figure 6 et Figure 7a sont des vues schématiques en perspective illustrant des étapes d'un procédé de fabrication d'un second moule selon l'invention.

Figure 7b, associée à la figure 7a, est une vue schématique partielle de dessus illustrant la morphologie de la couche structurée.

Figure 8a et Figure 9a sont des vues schématiques en perspective illustrant des étapes d'un procédé de fabrication d'un second moule selon l'invention.

Figure 8b, associée à la figure 8a, est une vue schématique partielle de dessus illustrant la morphologie de la couche du deuxième copolymère à blocs.

Figure 9b, associée à la figure 9a, est une vue schématique partielle de dessus illustrant la morphologie des seconds motifs lithographiques.

Figure 10a est une vue schématique en perspective d'un second moule créé par un procédé selon l'invention.

Figure 10b, associée à la figure 10a, est une vue schématique partielle illustrant les empreintes du second moule créé.

Figures 11a à 11h sont des vues schématiques en coupe illustrant différentes étapes d'un procédé de fabrication d'un calculateur selon l'invention.

Figures 12a à 12g sont des vues schématiques en coupe illustrant différentes étapes d'un procédé de fabrication d'un calculateur selon l'invention.

Il est à noter que les dessins décrits ci-avant sont schématiques et ne sont pas à l'échelle par souci de lisibilité. Les coupes sont effectuées suivant la normale à la surface du substrat.

## Exposé détaillé des modes de réalisation

Les éléments identiques ou assurant la même fonction porteront les mêmes références pour les différents modes de réalisation, par souci de simplification.

Un objet de l'invention est un procédé de fabrication de premier et second moules $M_1$, $M_2$ pour lithographie par nano-impression, comportant les étapes :

a) prévoir un substrat 1 comprenant une première couche de neutralisation $NL_1$ ;

b) former une couche 2 d'un premier copolymère à blocs 20, 21 sur la première couche de neutralisation $NL_1$ par une technique d'auto-assemblage, le premier copolymère à blocs 20, 21 comprenant des premier et deuxième monomères 20, 21, la première couche de neutralisation $NL_1$ possédant une affinité identique pour chacun des premier et deuxième monomères 20, 21 ; puis retirer sélectivement le deuxième monomère 21 de sorte que la couche 2 du premier copolymère à blocs 20, 21 comporte une série de premiers motifs 20 lithographiques à structure aléatoire s'étendant suivant une première direction, chacun des premiers motifs 20 lithographiques étant réalisé dans le premier monomère 20 ;

c) créer un premier moule $M_1$ comportant des empreintes $M_{10}$ formées à partir de la série de premiers motifs 20 lithographiques ;

d) prévoir une couche structurée 3 comportant une série de motifs 30, conforme à la série de premiers motifs 20 lithographiques, et s'étendant suivant la première direction, puis revêtir la couche structurée d'une seconde couche de neutralisation $NL_2$ ;

e) former une couche 4 d'un deuxième copolymère à blocs 40, 41 sur la seconde couche de neutralisation $NL_2$ par une technique d'auto-assemblage, le deuxième copolymère à blocs 40, 41 comprenant des troisième et quatrième monomères 40, 41, la seconde couche de neutralisation $NL_2$ possédant une affinité identique pour chacun des troisième et quatrième monomères 40, 41 ; puis retirer sélectivement le quatrième monomère 41 de sorte que la couche 4 du deuxième copolymère à blocs 40, 41 comporte une série de seconds motifs 40 lithographiques à structure aléatoire s'étendant suivant une seconde direction perpendiculaire à la première direction, chacun des seconds motifs 40 lithographiques étant réalisé dans le troisième monomère 40 ;

f) créer un second moule $M_2$ comportant des empreintes $M_{20}$ formées à partir de la série de seconds motifs 40 lithographiques.

## Substrat prévu lors de l'étape a)

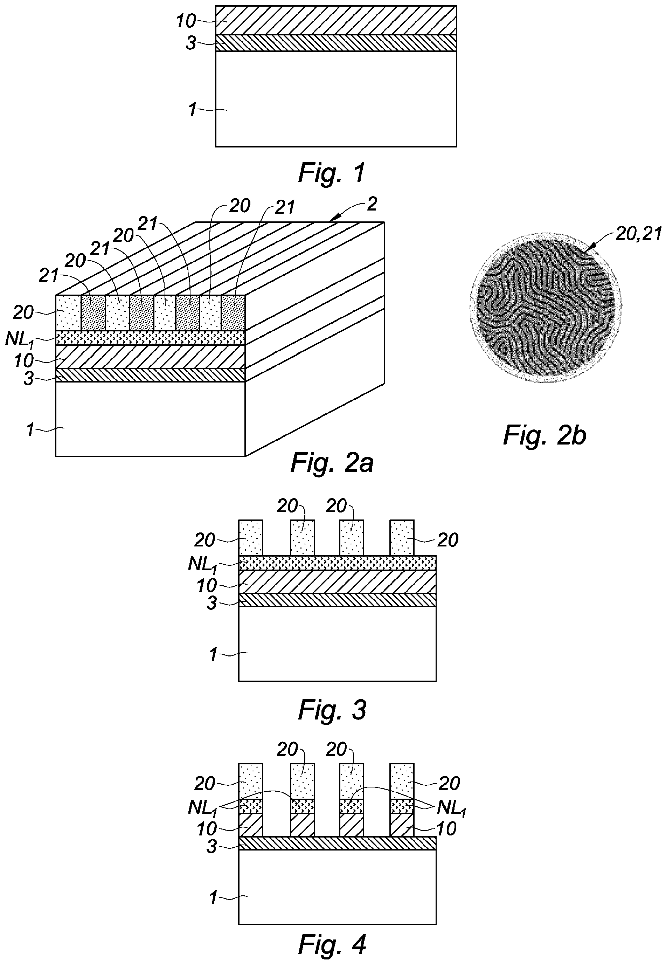

Comme illustré à la figure 1, le substrat 1 prévu lors de l'étape a) est avantageusement revêtu d'une couche d'oxyde 10, de préférence réalisée en $SiO_2$, sur laquelle est formée la première couche de neutralisation $NL_1$. La couche d'oxyde 10 peut présenter une épaisseur comprise entre 40 nm et 50 nm.

Le substrat 1 prévu lors de l'étape a) peut être réalisé en Si.

## Formation de la couche du premier copolymère à blocs

Le premier copolymère à blocs 20, 21 de la couche 2 est avantageusement sélectionné parmi :

- le polystyrène et le polyméthacrylate de méthyle, noté PS-PMMA ;
- le polystyrène et l'acide polylactique, noté PS-PLA ;
- le polystyrène et le poly(oxyde d'éthylène), noté PS-PEO ;
- le polystyrène et le polydiméthylsiloxane, noté PS-PDMS ;
- le polystyrène, le polyméthacrylate de méthyle, et le poly(oxyde d'éthylène), noté PS-PMMA-PEO ;
- le polystyrène et le poly(2-vinyl pyridine), noté PS-P2VP.

Les premier et deuxième monomères 20, 21 du premier copolymère à blocs 20, 21 sont des composés différents.

La première couche de neutralisation $NL_1$ est préférentiellement réalisée dans un polymère possédant une affinité identique pour chacun des premier et deuxième monomères 20, 21. La première couche de neutralisation $NL_1$ est préférentiellement greffée sur le substrat 1. Par « greffer », on entend la formation de liaisons covalentes entre le substrat 1 et les chaînes du polymère de la première couche de neutralisation $NL_1$. La masse molaire du polymère de la première couche de neutralisation $NL_1$ est avantageusement choisie de sorte que la première couche de neutralisation $NL_1$ présente une épaisseur inférieure à 10 nm (de préférence de l'ordre de 5 nm). L'étape de formation de la première couche de neutralisation $NL_1$ peut être exécutée à l'aide d'un traitement thermique, tel qu'un recuit thermique, ou par photoréticulation. A titre d'exemple, lorsque le premier copolymère à blocs 20, 21 est du polystyrène-b-poly(méthacrylate de méthyle), noté PS-b-PMMA, de forme lamellaire, le polymère de la première couche de neutralisation $NL_1$ est avantageusement du polystyrène-r-poly(méthacrylate de méthyle), noté PS-r-PMMA, comportant préférentiellement 50% en masse de PS et 50% en masse de PMMA. L'étape de formation de la première

couche de neutralisation $NL_1$ débute préférentiellement par un dépôt à la tournette (« *spin-coating* » en langue anglaise). Ce dépôt à la tournette peut être exécuté en diluant le polymère de la première couche de neutralisation $NL_1$ dans un solvant organique. Lorsque le polymère de la première couche de neutralisation $NL_1$ est le PS-r-PMMA, le solvant organique peut être de l'acétate de l'éther monométhylique du propylène glycol, noté PGMEA. La solution du polymère de la première couche de neutralisation $NL_1$, diluée dans le solvant organique, peut présenter une concentration massique de l'ordre de 2%. L'étape de formation de la première couche de neutralisation $NL_1$ peut se poursuivre par un recuit thermique à une température de l'ordre de 250°C pendant une durée de l'ordre de 2 minutes. Le recuit thermique peut être exécuté sur une table chauffante ou dans un four. Lorsque le polymère de la première couche de neutralisation $NL_1$ peut être réticulé, un tel recuit thermique permet la réticulation dudit polymère. L'étape de formation de la première couche de neutralisation $NL_1$ peut comporter ensuite une étape de rinçage au cours de laquelle le surplus de polymère de la première couche de neutralisation $NL_1$ est enlevé à l'aide d'un solvant. Lorsque le polymère de la première couche de neutralisation $NL_1$ est du PS-r-PMMA, le solvant est préférentiellement le PGMEA.

Le premier copolymère à blocs 20, 21 est préférentiellement formé lors de l'étape b) avec une morphologie lamellaire, les lamelles s'étendant suivant la première direction. La masse molaire du premier copolymère à blocs 20, 21 est choisie de manière à former, après auto-assemblage, des motifs périodiques (suivant la seconde direction) avec un pas compris entre 10 nm et 100 nm. L'étape b) est préférentiellement exécutée par un dépôt à la tournette. Le dépôt à la tournette peut être exécuté en diluant le premier copolymère à blocs 20, 21 dans un solvant organique. Lorsque le premier copolymère à blocs 20, 21 est réalisé en PS-b-PMMA, le solvant organique peut être du PGMEA. La solution du premier copolymère à blocs 20, 21, diluée dans le solvant organique, peut présenter une concentration massique de l'ordre de 2%. L'étape b) comporte un recuit thermique permettant l'auto-assemblage du premier copolymère à blocs PS-b-PMMA. Le recuit thermique est préférentiellement exécuté à une température de l'ordre de 220°C pendant une durée de l'ordre de 5 minutes. Comme illustré à la figure 3, l'étape b) comporte un retrait sélectif du deuxième monomère 21 du premier copolymère à blocs 20, 21, en l'espèce un retrait sélectif du PMMA de manière à ne conserver que la série de premiers motifs 20 lithographiques réalisés en PS. Le retrait sélectif du PMMA peut être exécuté selon un recuit thermique, en exposant la couche 2 du premier copolymère à blocs 20, 21 à un rayonnement ultraviolet (e.g. à une longueur d'onde de 172 nm), suivi d'un rinçage avec de l'acide acétique ou de l'isopropanol. Le retrait sélectif du PMMA peut également être exécuté à l'aide d'un plasma sélectif.

## Création du premier moule

Comme illustré à la figure 4, lorsque le substrat 1 prévu lors de l'étape a) est revêtu d'une couche d'oxyde 10, l'étape c) est avantageusement précédée d'une étape $c_0$) consistant à graver la première couche de neutralisation $NL_1$ et la couche d'oxyde 10 à travers la série de premiers motifs 20 lithographiques. Il est possible, à ce stade, d'éliminer le premier monomère 20 formant les premiers motifs 20 lithographiques, ainsi que les résidus de la première couche de neutralisation $NL_1$, puisque les premiers motifs 20 lithographiques ont été transférés dans la couche d'oxyde 10. Cette élimination du premier monomère 20 et des résidus de la première couche neutralisation $NL_1$ peut être exécutée par une gravure sélective vis-à-vis de la couche d'oxyde 10 et du substrat 1 (et le cas échéant de la couche 3 destinée à être structurée).

L'étape c) est exécutée par une technique connue de l'homme du métier, telle que décrite au chapitre 2 du livre « *Nano Lithography* », édité par Stefan Landis, ISBN : 978-1-118-62170-7.

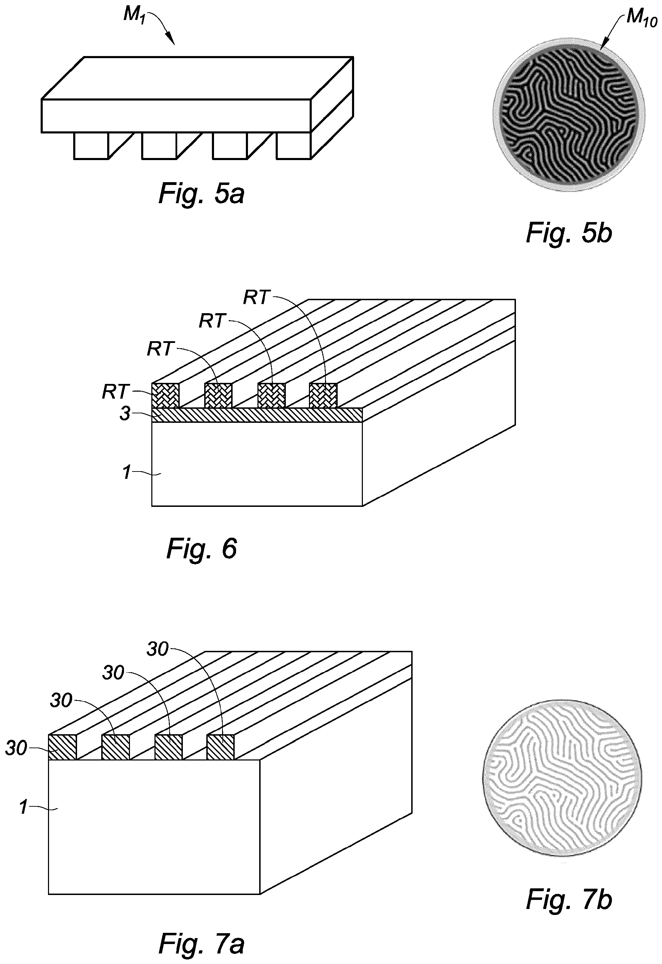

Le premier moule $M_1$ (illustré à la figure 5a) est créé lors de l'étape c) dans un matériau de type polymère.

## Couche structurée prévue lors de l'étape d)

La couche structurée 3 prévue lors de l'étape d) présente avantageusement une épaisseur comprise entre 5 nm et 15 nm.

L'étape d) comporte avantageusement les étapes :

$d_0$) prévoir une couche 3, destinée à être structurée, sur un substrat 1 support (par exemple en silicium) ;
$d_1$) déposer une résine thermoplastique RT sur la couche 3 ;
$d_2$) appliquer les empreintes $M_{10}$ du premier moule $M_1$ créé lors de l'étape c) sur la résine thermoplastique RT, à une température adaptée pour mettre en forme la résine thermoplastique RT ;
$d_3$) solidifier la résine thermoplastique RT mise en forme lors de l'étape $d_2$), de manière à obtenir un masque de lithographie (illustré à la figure 6) ;
$d_4$) graver la couche 3 à travers le masque de lithographie obtenu lors de l'étape $d_3$), de manière à structurer la couche 3 (illustré à la figure 7a).

Selon une variante, l'étape d) peut comporter les étapes :

$D_0$) prévoir une couche 3, destinée à être structurée, intercalée entre le substrat 1 et la couche d'oxyde 10 ;
$D_1$) éliminer la série de premiers motifs 20 lithographiques et la première couche de neutralisation $NL_1$, l'étape $D_1$) étant exécutée après l'étape $c_0$) de sorte que la couche d'oxyde 10 gravée lors de l'étape $c_0$)

forme un masque de lithographie ;

$D_2$) graver la couche 3 à travers le masque de lithographie formé lors de l'étape $D_1$), de manière à structurer la couche 3 ;

$D_3$) retirer la couche d'oxyde 10.

Comme illustré à la figure 1, lorsque le substrat 1 prévu lors de l'étape a) est revêtu d'une couche d'oxyde 10, la couche 3 prévue lors de l'étape $D_0$) est avantageusement intercalée entre le substrat 1 et la couche d'oxyde 10. L'étape $D_1$) peut être exécutée par une gravure sélective vis-à-vis de la couche d'oxyde 10 et de la couche 3 destinée à être structurée. L'étape $D_2$) peut être exécutée par une gravure sélective de la couche 3 par rapport au substrat 1, en utilisant comme masque de gravure la série de premiers motifs 20 lithographiques transférés dans la couche d'oxyde 10 lors de l'étape $c_0$). L'étape $D_3$) peut être exécutée par une gravure sélective de la couche d'oxyde 10 par rapport au substrat 1 et à la couche 3 structurée. La couche 3 prévue lors de l'étape $D_0$) est avantageusement réalisée dans un matériau choisi pour autoriser une gravure sélective de la couche d'oxyde 10, le matériau étant de préférence le TiN.

## Formation de la couche du deuxième copolymère à blocs

Le deuxième copolymère à blocs 40, 41 de la couche 4 est avantageusement sélectionné parmi :

- le polystyrène et le polyméthacrylate de méthyle, noté PS-PMMA ;
- le polystyrène et l'acide polylactique, noté PS-PLA ;
- le polystyrène et le poly(oxyde d'éthylène), noté PS-PEO ;
- le polystyrène et le polydiméthylsiloxane, noté PS-PDMS ;
- le polystyrène, le polyméthacrylate de méthyle, et le poly(oxyde d'éthylène), noté PS-PMMA-PEO ;
- le polystyrène et le poly(2-vinyl pyridine), noté PS-P2VP.

Les troisième et quatrième monomères 40, 41 du deuxième copolymère à blocs 40, 41 sont des composés différents. En revanche, le troisième monomère 40 du deuxième copolymère à blocs 40, 41 peut être identique au premier monomère 20 du premier copolymère à blocs 20, 21. De la même façon, le quatrième monomère 41 du deuxième copolymère à blocs 40, 41 peut être identique au deuxième monomère 21 du premier copolymère à blocs 20, 21.

La seconde couche de neutralisation $NL_2$ est préférentiellement réalisée dans un polymère possédant une affinité identique pour chacun des troisième et quatrième monomères 40, 41. La seconde couche de neutralisation $NL_2$ est préférentiellement greffée sur la couche structurée 3. Par « greffer », on entend la formation de liaisons covalentes entre la couche structurée 3 et les chaînes du polymère de la seconde couche de neutralisation $NL_2$. La masse molaire du polymère de la seconde couche de neutralisation $NL_2$ est avantageusement choisie de sorte que la seconde couche de neutralisation $NL_2$ présente une épaisseur inférieure à 10 nm (de préférence de l'ordre de 5 nm). L'étape de formation de la seconde couche de neutralisation $NL_2$ peut être exécutée à l'aide d'un traitement thermique, tel qu'un recuit thermique, ou par photoréticulation. A titre d'exemple, lorsque le deuxième copolymère à blocs 40, 41 est du polystyrène-b-poly(méthacrylate de méthyle), noté PS-b-PMMA, de forme lamellaire, le polymère de la seconde couche de neutralisation $NL_2$ est avantageusement du polystyrène-r-poly(méthacrylate de méthyle), noté PS-r-PMMA, comportant préférentiellement 50% en masse de PS et 50% en masse de PMMA. L'étape de formation de la seconde couche de neutralisation $NL_2$ débute préférentiellement par un dépôt à la tournette (« *spin-coating* » en langue anglaise). Ce dépôt à la tournette peut être exécuté en diluant le polymère de la seconde couche de neutralisation $NL_2$ dans un solvant organique. Lorsque le polymère de la seconde couche de neutralisation $NL_2$ est le PS-r-PMMA, le solvant organique peut être de l'acétate de l'éther monométhylique du propylène glycol, noté PGMEA. La solution du polymère de la seconde couche de neutralisation $NL_2$, diluée dans le solvant organique, peut présenter une concentration massique de l'ordre de 2%. L'étape de formation de la seconde couche de neutralisation $NL_2$ peut se poursuivre par un recuit thermique à une température de l'ordre de 250°C pendant une durée de l'ordre de 2 minutes. Le recuit thermique peut être exécuté sur une table chauffante ou dans un four. Lorsque le polymère de la seconde couche de neutralisation $NL_2$ peut être réticulé, un tel recuit thermique permet la réticulation dudit polymère. L'étape de formation de la seconde couche de neutralisation $NL_2$ peut comporter ensuite une étape de rinçage au cours de laquelle le surplus de polymère de la seconde couche de neutralisation $NL_2$ est enlevé à l'aide d'un solvant. Lorsque le polymère de la seconde couche de neutralisation $NL_2$ est du PS-r-PMMA, le solvant est préférentiellement le PGMEA.

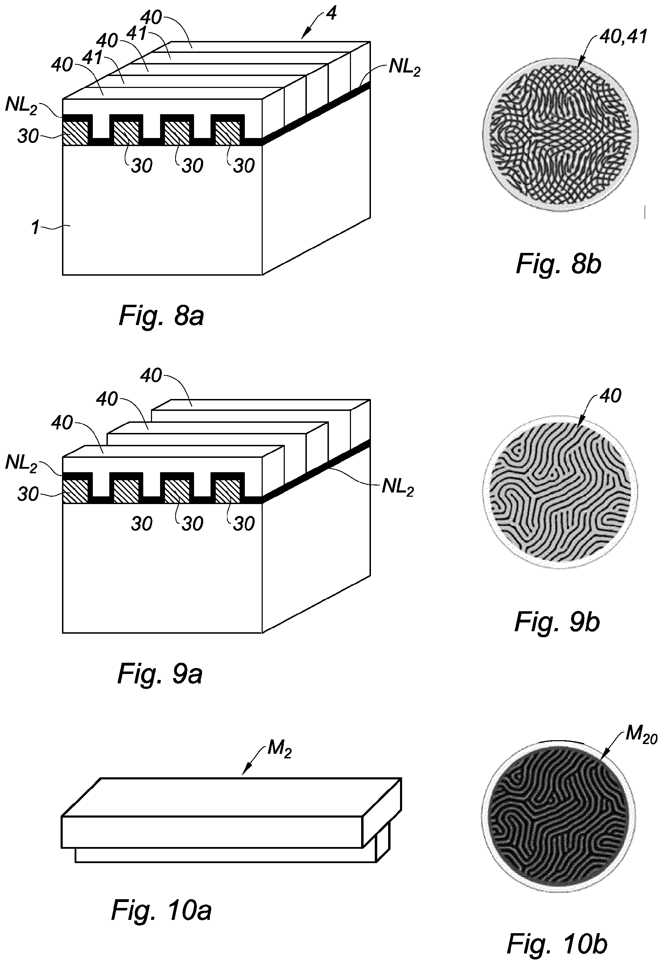

Le deuxième copolymère à blocs 40, 41 est préférentiellement formé lors de l'étape e) avec une morphologie lamellaire, les lamelles s'étendant suivant la seconde direction. La masse molaire du deuxième copolymère à blocs 40, 41 est choisie de manière à former, après auto-assemblage, des motifs périodiques (suivant la première direction) avec un pas compris entre 10 nm et 100 nm. L'étape e) est préférentiellement exécutée par un dépôt à la tournette. Le dépôt à la tournette peut être exécuté en diluant le deuxième copolymère à blocs 40, 41 dans un solvant organique. Lorsque le deuxième copolymère à blocs 40, 41 est réalisé en PS-b-PMMA, le solvant organique peut être du PGMEA. La solution du deuxième copolymère à blocs 40, 41, diluée dans le solvant organique, peut présenter une concentration massique de l'ordre de 2%. L'étape e) comporte un recuit thermique permettant l'auto-assemblage du deuxième copolymère à blocs PS-b-PMMA. Le recuit thermique est préférentiellement exécuté à une température de l'ordre de 220°C pendant une durée de l'ordre de 5 minutes. Comme illustré à la figure 9a, l'étape e) comporte un retrait sélectif du quatrième monomère 41 du deuxième copolymère à blocs 40, 41, en l'espèce un retrait sélectif du PMMA de manière à ne conserver que la série de seconds motifs 40 lithographiques réalisés en PS. Le retrait sélectif du PMMA peut être exécuté selon un recuit thermique, en exposant la couche 4 du deuxième copolymère à blocs 40, 41 à un rayonnement ultraviolet (e.g. à une longueur d'onde de 172 nm), suivi d'un rinçage avec de l'acide acétique ou de l'isopropanol. Le retrait sélectif du PMMA peut également être exécuté à l'aide d'un plasma sélectif.

## Création du second moule

L'étape f) est exécutée par une technique connue de l'homme du métier, telle que décrite au chapitre 2 du livre « *Nano Lithography* », édité par Stefan Landis, ISBN : 978-1-118-62170-7.

Le second moule $M_2$ (illustré à la figure 10a) est créé lors de l'étape f) dans un matériau de type polymère. Les empreintes $M_{20}$ du second moule $M_2$ sont par construction perpendiculaires aux empreintes $M_{10}$ du premier moule $M_1$. Les premier et second moules $M_1$, $M_2$ sont avantageusement munis de motifs d'alignement agencés pour faciliter leur positionnement relatif (l'un par rapport à l'autre), de manière à reproduire l'application de leurs empreintes $M_{10}$, $M_{20}$ perpendiculaires sur différentes couches (e.g. une résine thermoplastique).

Un objet de l'invention est un procédé de fabrication d'un calculateur C à réseaux de neurones récurrents, comportant les étapes successives :

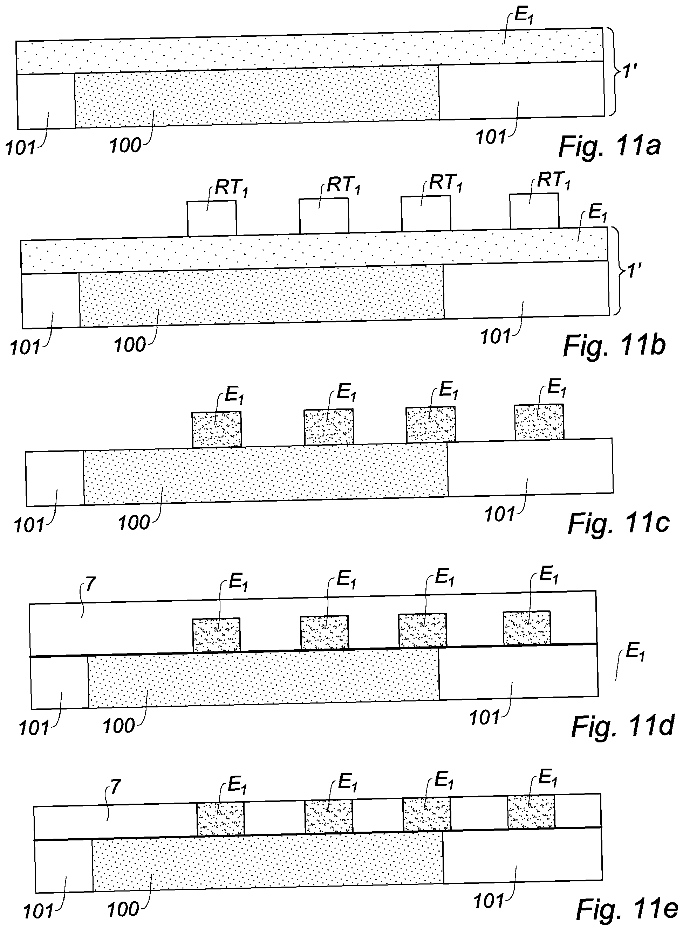

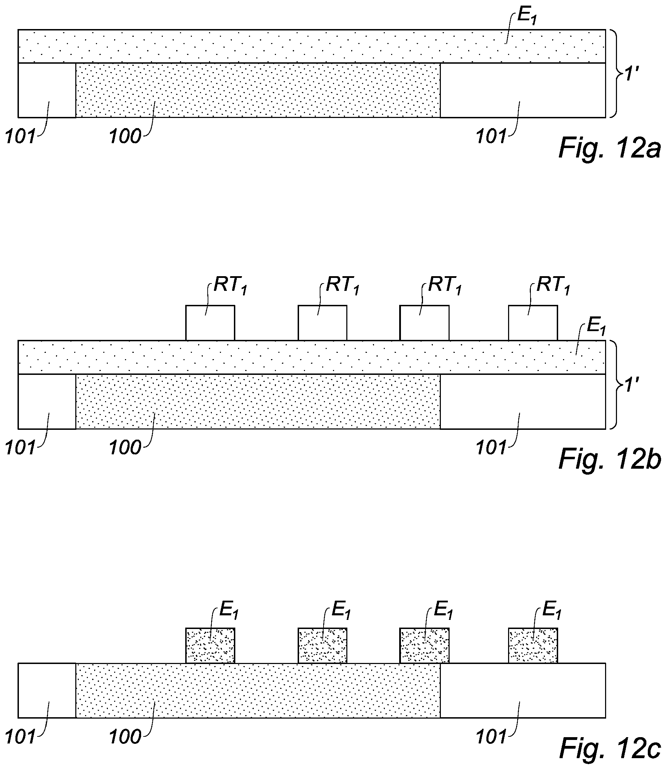

a') prévoir un substrat 1' comportant une première électrode $E_1$ (illustré aux figures 11a et 12a) ;
b'$_1$) déposer une résine thermoplastique $RT_1$ sur la première électrode $E_1$ ;
b'$_2$) appliquer les empreintes $M_{10}$ du premier moule $M_1$, fabriqué par un procédé conforme à l'invention, sur la résine thermoplastique $RT_1$, à une température adaptée pour mettre en forme la résine thermoplastique $RT_1$ ;
b'$_3$) solidifier la résine thermoplastique $RT_1$ mise en forme lors de l'étape b'$_2$), de manière à obtenir un masque de lithographie (illustré aux figures 11b et 12b) ;
b'$_4$) graver la première électrode $E_1$ à travers le masque de lithographie obtenu lors de l'étape b'$_3$), de manière à structurer la première électrode $E_1$ ;
b'$_5$) retirer la résine thermoplastique $RT_1$ (la situation à l'issue de l'étape b'$_5$) est illustrée aux figures 11c et 12c) ;
c') former une couche mémoire 5, de type mémoire résistive, sur la première électrode $E_1$ structurée lors de l'étape b'$_4$) ;

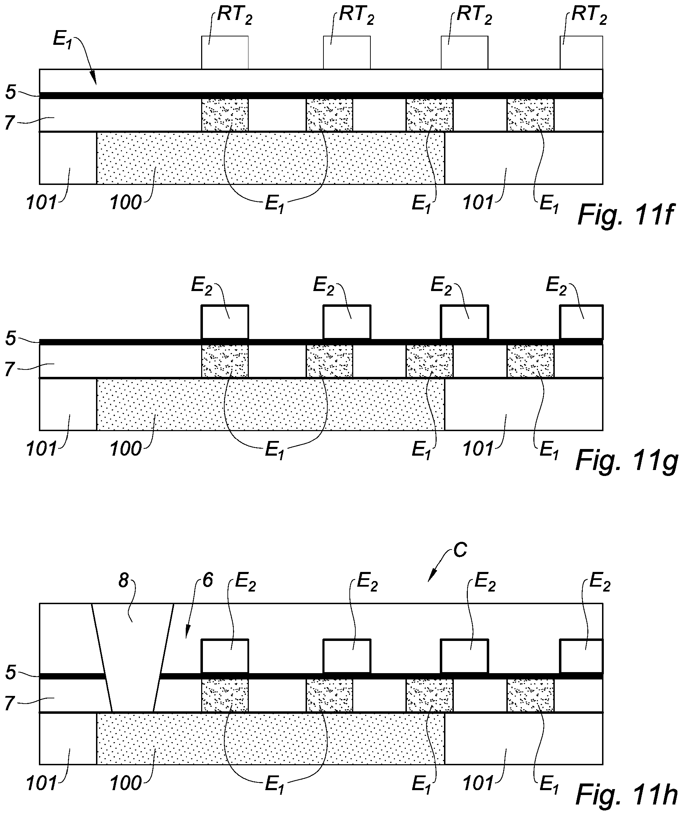

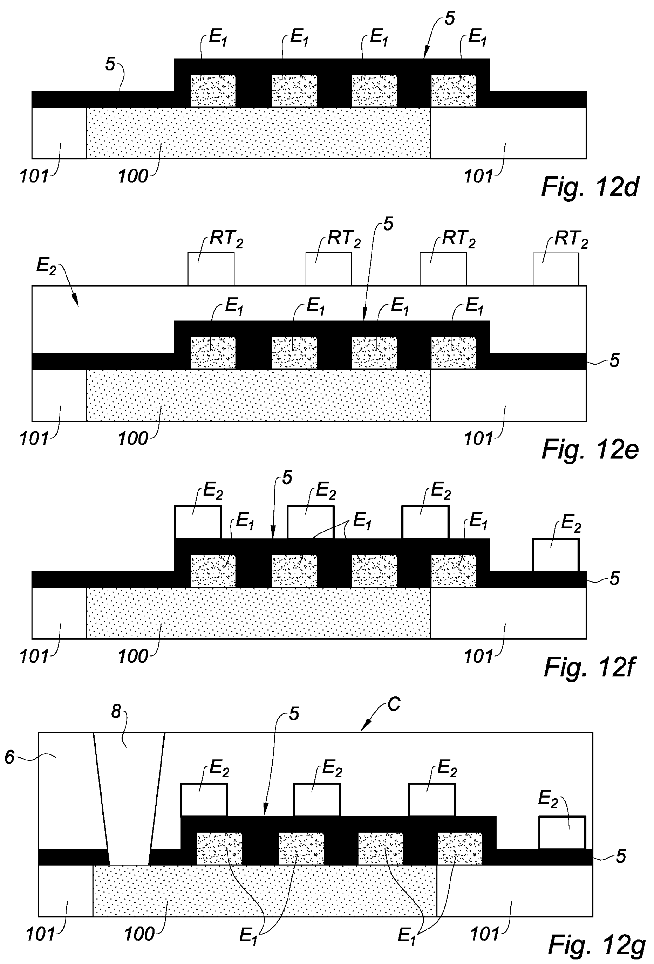

d') former une deuxième électrode $E_2$ sur la couche mémoire 5 ;
e'$_1$) déposer une résine thermoplastique $RT_2$ sur la deuxième électrode $E_2$ ;
e'$_2$) appliquer les empreintes $M_{20}$ du second moule $M_2$, fabriqué par un procédé conforme à l'invention, sur la résine thermoplastique $RT_2$, à une température adaptée pour mettre en forme la résine thermoplastique $RT_2$ ;
e'$_3$) solidifier la résine thermoplastique $RT_2$ mise en forme lors de l'étape e'$_2$), de manière à obtenir un masque de lithographie (la situation à l'issue de l'étape e'$_3$) est illustrée aux figures 11f et 12e) ;
e'$_4$) graver la deuxième électrode $E_2$ à travers le masque de lithographie obtenu lors de l'étape e'$_3$), de manière à structurer la deuxième électrode $E_2$ ;
e'$_5$) retirer la résine thermoplastique $RT_2$ (la situation à l'issue de l'étape e'$_5$) est illustrée aux figures 11g et 12f).

## Substrat prévu lors de l'étape a')

Le substrat 1' prévu lors de l'étape a') comporte préférentiellement une couche de métallisation 100 (pour la reprise de contact) et une couche d'un oxyde 101 tel que $SiO_2$ ou SiN. A titre d'exemple non limitatif, la couche de métallisation 100 peut être une structure du type Ti (10 nm)/AlCu (440 nm) / Ti (10 nm) / TiN (100 nm).

## Formation et structuration de la première électrode

La première électrode $E_1$ est avantageusement réalisée dans au moins un matériau sélectionné parmi Ti, TiN, Pt, Zr, Al, Hf, Ta, TaN, C, Cu, Ag. La première électrode $E_1$ peut être réalisée dans un alliage de ces matériaux.

La première électrode $E_1$ présente préférentiellement une épaisseur comprise entre 3 nm et 100 nm. A titre d'exemples non limitatifs, la première électrode $E_1$ peut être formée sur le substrat 1' par un dépôt physique en phase vapeur (PVD), un dépôt chimique en phase vapeur (CVD), ou encore par ALD (« *Atomic Layer Deposition* » en langue anglaise).

A titre d'exemple non limitatif, la résine thermoplastique $RT_1$ déposée sur la première électrode $E_1$ lors de l'étape b'$_1$) peut être une résine de polystyrène homopolymère (hPS), de préférence déposée par un dépôt à la tournette.

L'étape b'$_4$) peut être exécutée par une gravure au plasma. A titre d'exemples non limitatifs, il est possible d'utiliser comme gaz $O_2$, Ar, $COH_2$, $N_2H_2$. L'étape b'$_4$) peut être également exécutée à l'aide d'un traitement UV suivi d'un développement humide (e.g. acide acétique).

L'étape b'$_5$) peut être exécutée par une technique de « *stripping* » connue de l'homme du métier.

**Formation de la couche mémoire**

La couche mémoire 5 formée lors de l'étape c') est avantageusement réalisée dans au moins un matériau sélectionné parmi $HfO_2$, $Al_2O_3$, $SiO_2$, ZrO, un oxyde de titane, un chalcogénure, $Ta_2O_5$. La couche mémoire 5 peut être formée d'une pluralité de sous-couches réalisées dans ces matériaux. A titre d'exemples non limitatifs, le chalcogénure peut être GeSe ou GeSbTe.

La couche mémoire 5 présente avantageusement une épaisseur inférieure ou égale à 10 nm.

**Formation et structuration de la deuxième électrode**

La deuxième électrode $E_2$ est avantageusement réalisée dans au moins un matériau sélectionné parmi Ti, TiN, Pt, Zr, Al, Hf, Ta, TaN, C, Cu, Ag. La deuxième électrode $E_2$ peut être réalisée dans un alliage de ces matériaux.

La deuxième électrode $E_2$ présente préférentiellement une épaisseur comprise entre 3 nm et 100 nm. A titre d'exemples non limitatifs, la deuxième électrode $E_2$ peut être formée sur la couche mémoire 5 par un dépôt physique en phase vapeur (PVD), un dépôt chimique en phase vapeur (CVD), ou encore par ALD (« *Atomic Layer Deposition* » en langue anglaise).

A titre d'exemple non limitatif, la résine thermoplastique $RT_2$ déposée sur la deuxième électrode $E_2$ lors de l'étape e'$_1$) peut être une résine de polystyrène homopolymère (hPS), de préférence déposée par un dépôt à la tournette.

L'étape e'$_2$) peut s'effectuer en alignant les premier et second moules $M_1$, $M_2$ grâce aux motifs d'alignement prévus à cet effet, de sorte que les empreintes $M_{20}$ du second moule $M_2$ sont appliquées perpendiculairement à la structuration de la première électrode $E_1$.

L'étape e'$_4$) peut être exécutée par une gravure au plasma. A titre d'exemples non limitatifs, il est possible d'utiliser comme gaz $O_2$, Ar, $COH_2$, $N_2H_2$. L'étape e'$_4$) peut être également exécutée à l'aide d'un traitement UV suivi d'un développement humide (e.g. acide acétique).

L'étape e'$_5$) peut être exécutée par une technique de « *stripping* » connue de l'homme du métier.

Encapsulation

Comme illustré aux figures 11h et 12g, le procédé comporte avantageusement une étape f) consistant à former une couche d'encapsulation 6 sur la deuxième électrode $E_2$ structurée lors de l'étape e'$_4$), l'étape f) étant exécutée après l'étape e'$_5$).La couche d'encapsulation 6 est préférentiellement une couche d'un oxyde tel que $SiO_2$ ou SiN.

Par ailleurs, comme illustré à la figure 11d, le procédé comporte avantageusement une étape b'$_6$) consistant à former une couche d'encapsulation 7 sur la première électrode $E_1$ structurée. L'étape b'$_6$) est exécutée après l'étape b'$_5$) et avant l'étape c'). La couche d'encapsulation 7 est préférentiellement une couche d'un oxyde tel que $SiO_x$ ou SiN. Comme illustré à la figure 11e, l'étape b'$_6$) est avantageusement suivie d'une étape b'$_7$) d'aplanissement de la couche d'encapsulation 7 pouvant être exécutée par polissage mécano-chimique (CMP pour « *Chemical-Mechanical Polishing* » en langue anglaise). En l'absence des étapes b'$_6$) et b'$_7$), la couche mémoire 5 formée lors de l'étape c') suit la topologie de la première électrode $E_1$ structurée, comme illustré à la figure 12d.

Plus précisément, en l'absence des étapes b'$_6$) et b'$_7$), la couche mémoire 5 est formée lors de l'étape c'), directement sur le substrat 1 et directement sur la première électrode $E_1$ structurée, en suivant la topologie de la première électrode $E_1$ structurée. Ce mode de réalisation est particulièrement avantageux car il permet de s'affranchir notamment de l'étape b'$_7$) de polissage mécano-chimique qui peut s'avérer délicate à effectuer en raison de la géométrie de la première électrode $E_1$ structurée (le ratio entre son épaisseur et son pas étant faible).

En l'absence des étapes b'$_6$) et b'$_7$), la couche mémoire 5 formée lors de l'étape c') présente avantageusement une épaisseur, notée E, vérifiant :

$$p/2 \leq E \leq p$$

où p est le pas de la première électrode $E_1$ structurée formant une structure périodique. Une telle épaisseur E de la couche mémoire 5 permet d'obtenir une topologie de surface quasi-plane de manière à faciliter la formation de la deuxième électrode $E_2$ lors de l'étape d').

Le pas p de la première électrode $E_1$ structurée correspond au pas des empreintes $M_{10}$ du premier moule $M_1$, c'est-à-dire au pas de la série des premiers motifs 20 lithographiques. A titre d'exemple non limitatif, lorsque la couche 2 du premier copolymère à blocs 20, 21 formée lors de l'étape b) est réalisée en PS-PMMA, le pas est défini par la masse molaire du premier copolymère à blocs 20, 21, comme évoqué dans le document Kim et al, « Directed assembly of high molecular weight block polymers : highly ordered line patterns of perpendicularly oriented lamellae with large periods », ACS Nano, 7(3), pp. 1952-60, 2013. On pourra donc choisir la masse molaire du premier copolymère à blocs 20, 21 de manière à contrôler le pas p de la première électrode $E_1$ structurée. A titre d'exemple non limitatif, le pas p de la première électrode $E_1$ structurée peut être de l'ordre de 20 nm.

En l'absence des étapes b'$_6$) et b'$_7$), la couche mémoire 5 est avantageusement réalisée dans au moins un matériau sélectionné dans le groupe comportant :

- $HfO_x$, x<2 ;
- $Al_2O_x$, x<3 ;
- $SiO_x$, x<2 ;
- $ZrO_x$, x<3 ;
- $TiO_x$, x<2 ;
- $Ta_2O_x$, x<5.

De tels matériaux sont des oxydes sous-stœchiométriques permettant de créer un filament électriquement conducteur lorsqu'ils sont soumis à une différence de potentiels élevée. De tels matériaux peuvent ainsi former, avec les première et deuxième électrodes $E_1$, $E_2$ structurée, une mémoire résistive.

## Contacts électriques

Comme illustré aux figures 11h et 12g, le procédé comporte préférentiellement une étape g') consistant à former un plot 8 de contact électrique, en contact avec la couche de métallisation 100. L'étape g') est exécutée après l'étape f). L'étape g') comporte une étape de gravure d'une partie de la couche d'encapsulation 6 formée sur la deuxième électrode $E_2$ structurée.

## Revendications

1. Procédé de fabrication de premier et second moules ($M_1$, $M_2$) pour lithographie par nano-impression, comportant les étapes :

   a) prévoir un substrat (1) comprenant une première couche de neutralisation ($NL_1$) ;
   b) former une couche (2) d'un premier copolymère à blocs (20, 21) sur la première couche de neutralisation ($NL_1$) par une technique d'auto-assemblage, le premier copolymère à blocs (20, 21) comprenant des premier et deuxième monomères (20, 21), la première couche de neutralisation ($NL_1$) possédant une affinité identique pour chacun des premier et deuxième monomères (20, 21) ; puis retirer sélectivement le deuxième monomère (21) de sorte que la couche (2) du premier copolymère à blocs (20, 21) comporte une série de premiers motifs (20) lithographiques à structure aléatoire s'étendant suivant une première direction, chacun des premiers motifs (20) lithographiques étant réalisé dans le premier monomère (20) ;
   c) créer un premier moule ($M_1$) comportant des empreintes ($M_{10}$) formées à partir de la série de premiers motifs (20) lithographiques ;
   d) prévoir une couche structurée (3) comportant une série de motifs (30), conforme à la série de premiers motifs (20) lithographiques, et s'étendant suivant la première direction, puis revêtir la couche structurée (3) d'une seconde couche de neutralisation ($NL_2$) ;
   e) former une couche (4) d'un deuxième copolymère à blocs (40, 41) sur la seconde couche de neutralisation ($NL_2$) par une technique d'auto-assemblage, le deuxième copolymère à blocs (40, 41) comprenant des troisième et quatrième monomères (40, 41), la seconde couche de neutralisation ($NL_2$) possédant une affinité identique pour chacun des troisième et quatrième monomères (40, 41) ; puis retirer sélectivement le quatrième monomère (41) de sorte que la couche (4) du deuxième copolymère à blocs (40, 41) comporte une série de seconds motifs (40) lithographiques à structure aléatoire s'étendant suivant une seconde direction perpendiculaire à la première direction, chacun des seconds motifs (40) lithographiques étant réalisé dans le troisième monomère (40) ;
   f) créer un second moule ($M_2$) comportant des empreintes ($M_{20}$) formées à partir de la série de seconds motifs (40) lithographiques.

2. Procédé selon la revendication 1, dans lequel le substrat (1) prévu lors de l'étape a) est revêtu d'une couche d'oxyde (10), de préférence réalisée en $SiO_2$, sur laquelle est formée la première couche de neutralisation ($NL_1$) ; et l'étape c) est précédée d'une étape $c_0$) consistant à graver la première couche de neutralisation ($NL_1$) et la couche d'oxyde (10) à travers la série de premiers motifs (20) lithographiques.

3. Procédé selon la revendication 1 ou 2, dans lequel la couche structurée (3) prévue lors de l'étape d) présente une épaisseur comprise entre 5 nm et 15 nm.

4. Procédé selon l'une des revendications 1 à 3, dans lequel l'étape d) comporte les étapes :

   $d_0$) prévoir une couche (3), destinée à être structurée, sur un substrat (1) support ;
   $d_1$) déposer une résine thermoplastique (RT) sur la couche (3) ;
   $d_2$) appliquer les empreintes ($M_{10}$) du premier moule ($M_1$) créé lors de l'étape c) sur la résine thermoplastique (RT), à une température adaptée pour mettre en forme la résine thermoplastique (RT) ;
   $d_3$) solidifier la résine thermoplastique (RT) mise en forme lors de l'étape $d_2$), de manière à obtenir un masque de lithographie ;
   $d_4$) graver la couche (3) à travers le masque de lithographie obtenu lors de l'étape $d_3$), de manière à structurer la couche (3).

5. Procédé selon la revendication 2, dans lequel l'étape d) comporte les étapes :

   $D_0$) prévoir une couche (3), destinée à être structurée, intercalée entre le substrat (1) et la couche d'oxyde (10) ;
   $D_1$) éliminer la série de premiers motifs (20) lithographiques et la première couche de neutralisation ($NL_1$), l'étape $D_1$) étant exécutée après l'étape $c_0$) de sorte que la couche d'oxyde (10) gravée lors de l'étape $c_0$) forme un masque de

lithographie ;
D$_2$) graver la couche (3) à travers le masque de lithographie formé lors de l'étape D$_1$), de manière à structurer la couche (3) ;
D$_3$) retirer la couche d'oxyde (10).

6. Procédé selon la revendication 5, dans lequel la couche (3) prévue lors de l'étape D$_0$) est réalisée dans un matériau choisi pour autoriser une gravure sélective de la couche d'oxyde (10), le matériau étant de préférence le TiN.

7. Procédé selon l'une des revendications 1 à 6, dans lequel les premier et deuxième copolymères à blocs (20, 21 ; 40, 41) sont sélectionnés parmi :

- le polystyrène et le polyméthacrylate de méthyle, noté PS-PMMA ;
- le polystyrène et l'acide polylactique, noté PS-PLA ;
- le polystyrène et le poly(oxyde d'éthylène), noté PS-PEO ;
- le polystyrène et le polydiméthylsiloxane, noté PS-PDMS ;
- le polystyrène, le polyméthacrylate de méthyle, et le poly(oxyde d'éthylène), noté PS-PMMA-PEO ;
- le polystyrène et le poly(2-vinyl pyridine), noté PS-P2VP.

8. Procédé de fabrication d'un calculateur (C) à réseaux de neurones récurrents, comportant les étapes successives :

a') prévoir un substrat (1') comportant une première électrode (E$_1$) ;
b'$_1$) déposer une résine thermoplastique (RT$_1$) sur la première électrode (E$_1$) ;
b'$_2$) appliquer les empreintes (M$_{10}$) du premier moule (M$_1$), fabriqué par le procédé selon l'une des revendications 1 à 9, sur la résine thermoplastique (RT$_1$), à une température adaptée pour mettre en forme la résine thermoplastique (RT$_1$) ;
b'$_3$) solidifier la résine thermoplastique (RT$_1$) mise en forme lors de l'étape b'$_2$), de manière à obtenir un masque de lithographie ;
b'$_4$) graver la première électrode (E$_1$) à travers le masque de lithographie obtenu lors de l'étape b'$_3$), de manière à structurer la première électrode (E$_1$) ;
b'$_5$) retirer la résine thermoplastique (RT$_1$) ;
c') former une couche mémoire (5), de type mémoire résistive, sur la première électrode (E$_1$) structurée lors de l'étape b'$_4$) ;
d') former une deuxième électrode (E$_2$) sur la couche mémoire (5) ;
e'$_1$) déposer une résine thermoplastique (RT$_2$)

sur la deuxième électrode (E$_2$) ;
e'$_2$) appliquer les empreintes (M$_{20}$) du second moule (M$_2$), fabriqué par le procédé selon l'une des revendications 1 à 9, sur la résine thermoplastique (RT$_2$), à une température adaptée pour mettre en forme la résine thermoplastique (RT$_2$) ;
e'$_3$) solidifier la résine thermoplastique (RT$_2$) mise en forme lors de l'étape e'$_2$), de manière à obtenir un masque de lithographie ;
e'$_4$) graver la deuxième électrode (E$_2$) à travers le masque de lithographie obtenu lors de l'étape e'$_3$), de manière à structurer la deuxième électrode (E$_2$) ;
e'$_5$) retirer la résine thermoplastique (RT$_2$).

9. Procédé selon la revendication 8, dans lequel la couche mémoire (5) formée lors de l'étape c') est réalisée dans au moins un matériau sélectionné parmi HfO$_2$, Al$_2$O$_3$, SiO$_2$, ZrO, un oxyde de titane, un chalcogénure, Ta$_2$O$_5$.

10. Procédé selon la revendication 8 ou 9, dans lequel les première et deuxième électrodes (E$_1$, E$_2$) sont réalisées dans au moins un matériau sélectionné parmi Ti, TiN, Pt, Zr, Al, Hf, Ta, TaN, C, Cu, Ag.

11. Procédé selon l'une des revendications 8 à 10, comportant une étape f) consistant à former une couche d'encapsulation (6) sur la deuxième électrode (E$_2$) structurée lors de l'étape e'$_4$), l'étape f) étant exécutée après l'étape e'$_5$).

12. Procédé selon l'une des revendications 8 à 11, dans lequel la première électrode (E$_1$) structurée lors de l'étape b'$_4$) présente un pas, noté p, et dans lequel l'étape c') est exécutée de sorte que la couche mémoire (5) présente une épaisseur, notée E, vérifiant :

$$p/2 \leq E \leq p.$$

**Patentansprüche**

1. Verfahren zur Herstellung einer ersten und einer zweiten Form (M$_1$, M$_2$) für die Lithografie durch Nanodruck, wobei es die folgenden Schritte umfasst:

a) Bereitstellen eines Substrats (1), das eine erste Neutralisierungsschicht (NL$_1$) umfasst;
b) Bilden einer Schicht (2) aus einem ersten Blockcopolymer (20, 21) auf der ersten Neutralisierungsschicht (NL$_1$) mittels einer Technik des selbsttätigen Zusammenfügens, wobei das erste Blockcopolymer (20, 21) erste und zweite Monomers (20, 21) umfasst, wobei die erste Neutralisierungsschicht (NL1) für jedes der ersten und zweiten Monomere (20, 21) eine identische Affinität besitzt; anschließend selektives Entfernen des zweiten Monomers (21), sodass die Schicht (2) des ersten Blockcopolymers (20, 21) eine Abfolge erster lithografischer Bausteine (20) mit zufallsbedingter Struktur aufweist, die sich gemäß einer ersten Richtung erstreckt, wobei jeder der ersten lithografischen Bausteine (20) aus dem ersten Monomer (20) besteht;

c) Herstellen einer ersten Form ($M_1$), die Abdruckelemente ($M_{10}$) aufweist, welche ausgehend von der Abfolge erster lithografischer Bausteine (20) gebildet wurden;

d) Bereitstellen einer strukturierten Schicht (3), die eine Abfolge von Bausteinen (30) aufweist, welche der Abfolge erster lithografischer Bausteine (20) entspricht, und die sich gemäß der ersten Richtung erstreckt, wobei die strukturierte Schicht (3) anschließend mit einer zweiten Neutralisierungsschicht ($NL_2$) überzogen wird;

e) Bilden einer Schicht (4) aus einem zweiten Blockcopolymer (40, 41) auf der zweiten Neutralisierungsschicht ($NL_2$) mittels einer Technik des selbsttätigen Zusammenfügens, wobei das zweite Blockcopolymer (40, 41) dritte und vierte Monomere (40, 41) umfasst, wobei die zweite Neutralisierungsschicht ($NL_2$) für jedes der dritten und vierten Monomere (40, 41) eine identische Affinität besitzt; anschließend selektives Entfernen des vierten Monomers (41), sodass die Schicht (4) des zweiten Blockcopolymers (40, 41) eine Abfolge zweiter lithografischer Bausteine (40) mit zufallsbedingter Struktur aufweist, wobei sie sich gemäß einer zweiten Richtung erstreckt, die rechtwinklig zu der ersten Richtung ist, wobei jeder der zweiten lithografischen Bausteine (40) aus dem dritten Monomer (40) besteht.

f) Herstellen einer zweiten Form ($M_2$), die Abdruckelemente ($M_{20}$) aufweist, welche ausgehend von der Abfolge zweiter lithografischer Elemente (40) gebildet wurden.

2. Verfahren nach Anspruch 1, wobei das Substrat (1), welches im Schritt a) bereitgestellt wird, mit einer Oxidschicht (10) überzogen ist, welche vorzugsweise aus $SiO_2$ besteht und auf welcher die erste Neutralisierungsschicht ($NL_1$) gebildet ist; und wobei dem Schritt c) ein Schritt $c_0$) vorangeht, welcher darin besteht, die erste Neutralisierungsschicht ($NL_1$) und die Oxidschicht (10) durch die Abfolge erster lithografischer Bausteine (20) hindurch zu gravieren.

3. Verfahren nach Anspruch 1 oder 2, wobei die strukturierte Schicht (3), welche im Schritt d) bereitgestellt wird, eine Dicke im Bereich von 5 nm bis 15 nm aufweist.

4. Verfahren nach einem der Ansprüche 1 bis 3, wobei der Schritt d) die folgenden Schritte aufweist:

$d_0$) Bereitstellen einer Schicht (3), die dazu bestimmt ist, strukturiert zu werden, auf einem Trägersubstrat (1);

$d_1$) Aufbringen eines thermoplastischen Harzes (RT) auf die Schicht (3);

$d_2$) Drücken der Abdruckelemente ($M_{10}$) der ersten Form ($M_1$), welche in Schritt c) hergestellt wurde, auf das thermoplastische Harz (RT), bei einer Temperatur, die dazu geeignet ist, dem thermoplastischen Harz (RT) eine Form zu verleihen;

$d_3$) Erstarrenlassen des thermoplastischen Harzes (RT), welchem in Schritt $d_2$) eine Form verliehen wurde, sodass eine Lithografiemaske erhalten wird;

$d_4$) Gravieren der Schicht (3) durch die Lithografiemaske hindurch, wie sie im Schritt $d_3$) erhalten wurde, sodass die Schicht (3) strukturiert wird.

5. Verfahren nach Anspruch 2, wobei der Schritt d) die folgenden Schritte aufweist:

$D_0$) Bereitstellen einer Schicht (3), die dazu bestimmt ist, strukturiert zu werden, wobei sie zwischen dem Substrat (1) und der Oxidschicht (10) eingefügt wird;

$D_1$) Entfernen der Abfolge erster lithografischer Bausteine (20) und der ersten Neutralisierungsschicht ($NL_1$), wobei der Schritt $D_1$) nach dem Schritt $c_0$) ausgeführt wird, sodass die Oxidschicht (10), welche im Schritt $c_0$) graviert wurde, eine Lithografiemaske bildet;

$D_2$) Gravieren der Schicht (3) durch die Lithografiemaske hindurch, wie sie im Schritt $D_1$) gebildet wurde, sodass die Schicht (3) strukturiert wird;

$D_3$) Entfernen der Oxidschicht (10).

6. Verfahren nach Anspruch 5, wobei die Schicht (3), welche im Schritt $D_0$) bereitgestellt wird, aus einem Material besteht, das derart ausgewählt ist, dass ein selektives Gravieren der Oxidschicht (10) ermöglicht wird, wobei es sich bei dem Material vorzugsweise um TiN handelt.

7. Verfahren nach einem der Ansprüche 1 bis 6, wobei das erste und das zweite Blockcopolymer (20, 21; 40, 41) aus den folgenden ausgewählt sind:

- Polystyrol und Polymethylmethacrylat; bezeichnet als PS-PMMA;
- Polystyrol und Polymilchsäure, bezeichnet als PS-PLA;
- Polystyrol und Polyethylenoxid, bezeichnet als PS-PEO;
- Polystyrol und Polydimethylsiloxan, bezeichnet als PS-PDMS;
- Polystyrol, Polymethylmethacrylat und Polyethylenoxid, bezeichnet als PS-PMMA-PEO;
- Polystyrol und Poly(2-vinylpyridin), bezeichnet als PS-P2VP.

8. Verfahren zur Herstellung eines Rechners (C) mit Netzwerken wiederkehrender Neuronen, wobei es die nacheinander die folgenden Schritte umfasst:

a') Bereitstellen eines Substrats (1'), das eine erste Elektrode ($E_1$) aufweist;
b'$_1$) Aufbringen eines thermoplastischen Harzes ($RT_1$) auf die erste Elektrode ($E_1$);
b'$_2$) Drücken der Abdruckelemente ($M_{10}$) der ersten Form ($M_1$), welche mittels des Verfahrens nach einem der Ansprüche 1 bis 9 hergestellt wurde, auf das thermoplastische Harz ($RT_1$), bei einer Temperatur, die dafür geeignet ist, dem thermoplastischen Harz ($RT_1$) eine Form zu verleihen;
b'$_3$) Erstarrenlassen des thermoplastischen Harzes ($RT_1$), welchem in Schritt b'$_2$) eine Form verliehen wurde, sodass eine Lithografiemaske erhalten wird;
b'$_4$) Gravieren der ersten Elektrode ($E_1$) durch die Lithografiemaske hindurch, wie sie im Schritt b'$_3$) erhalten wurde, sodass die erste Elektrode ($E_1$) strukturiert wird;
b'$_5$) Entfernen des thermoplastischen Harzes ($RT_1$);
c') Bilden einer Speicherschicht (5), vom Typ widerstandsbasierter Speicher, auf der ersten Elektrode ($E_1$), welche im Schritt b'$_4$) strukturiert wurde;
d') Bilden einer zweiten Elektrode ($E_2$) auf der Speicherschicht (5);
e'$_1$) Aufbringen eines thermoplastischen Harzes ($RT_2$) auf die zweite Elektrode (E2);
e'$_2$) Drücken der Abdruckelemente ($M_{20}$) der zweiten Form ($M_2$), welche mittels des Verfahrens nach einem der Ansprüche 1 bis 9 hergestellt wurde, auf das thermoplastische Harz ($RT_2$), bei einer Temperatur, die dafür geeignet ist, dem thermoplastischen Harz ($RT_2$) eine Form zu verleihen;
e'$_3$) Erstarrenlassen des thermoplastischen Harzes ($RT_2$), welchem in Schritt e'$_2$) eine Form verliehen wurde, sodass eine Lithografiemaske erhalten wird;
e'$_4$) Gravieren der zweiten Elektrode ($E_2$) durch die Lithografiemaske hindurch, wie sie im Schritt e'$_3$) erhalten wurde, sodass die zweite Elektrode ($E_2$) strukturiert wird;
e'$_5$) Entfernen des thermoplastischen Harzes ($RT_2$);

9. Verfahren nach Anspruch 8, wobei die Speicherschicht (5), welche im Schritt c') gebildet wurde, aus mindestens einem Material besteht, das aus $HfO_2$, $Al_2O_3$, $SiO_2$, $ZrO$, einem Titanoxid, einem Chalkogenid, $Ta_2O_5$ ausgewählt ist.

10. Verfahren nach Anspruch 8 oder 9, wobei die erste und die zweite Elektrode ($E_1$, $E_2$) aus mindestens einem Material bestehen, das aus Ti, TiN, Pt, Zr, Al, Hf, Ta, TaN, C, Cu, Ag ausgewählt ist.

11. Verfahren nach einem der Ansprüche 8 bis 10, das einen Schritt f') aufweist, der darin besteht, eine Verkapselungsschicht (6) auf der zweiten Elektrode ($E_2$) zu bilden, welche im Schritt e'$_4$) strukturiert wurde, wobei der Schritt f) nach dem Schritt e'$_5$) ausgeführt wird.

12. Verfahren nach einem der Ansprüche 8 bis 11, wobei die erste Elektrode ($E_1$), welche im Schritt b'$_4$) strukturiert wurde, einen Wiederholabstand aufweist, der mit p bezeichnet wird, und wobei der Schritt c') derart ausgeführt wird, dass die Speicherschicht (5) eine Dicke aufweist, die mit E bezeichnet wird und für die Folgendes gilt:

$$p/2 \leq E \leq p.$$

## Claims

1. Method for fabricating first and second molds ($M_1$, $M_2$) for lithography by nano-imprinting, comprising the steps:

a) provide a substrate (1) comprising a first neutralization layer ($NL_1$);
b) form a layer (2) of a first block copolymer (20, 21) on the first neutralization layer ($NL_1$) by a technique of self-assembly, the first block copolymer (20, 21) comprising first and second monomers (20, 21), the first neutralization layer ($NL_1$) having an identical affinity for each of the first and second monomers (20, 21); then selectively remove the second monomer (21) such that the layer (2) of the first block copolymer (20, 21) comprises a series of first lithographic patterns (20) with a random structure extending in a first direction, each of the first lithographic patterns (20) being formed in the first monomer (20);
c) create a first mold ($M_1$) comprising impressions ($M_{10}$) formed from the series of first lithographic patterns (20);
d) provide a structured layer (3) comprising a series of patterns (30), conforming to the series of first lithographic patterns (20) and extending in the first direction, then coat the structured layer (3) with a second neutralization layer (NL$_2$);

e) form a layer (4) of a second block copolymer (40, 41) on the second neutralization layer (NL$_2$) by a technique of self-assembly, the second block copolymer (40, 41) comprising third and fourth monomers (40, 41), the second neutralization layer (NL$_2$) having an identical affinity for each of the third and fourth monomers (40, 41); then selectively remove the fourth monomer (41) such that the layer (4) of the second block copolymer (40, 41) comprises a series of second lithographic patterns (40) with a random structure extending in a second direction perpendicular to the first direction, each of the second lithographic patterns (40) being formed in the third monomer (40);

f) create a second mold (M$_2$) comprising impressions (M$_{20}$) formed from the series of second lithographic patterns (40).

2. Method according to Claim 1, in which the substrate (1) provided during the step a) is coated with an oxide layer (10), preferably of SiO$_2$, on which the first neutralization layer (NL$_1$) is formed; and the step c) is preceded by a step c$_0$) consisting in etching the first neutralization layer (NL$_1$) and the oxide layer (10) through the series of first lithographic patterns (20).

3. Method according to either of Claims 1 and 2, in which the structured layer (3) provided during the step d) has a thickness in the range between 5 nm and 15 nm.

4. Method according to one of Claims 1 to 3, in which the step d) comprises the steps:

d$_0$) provide a layer (3), intended to be structured, on a carrier substrate (1);

d$_1$) deposit a thermoplastic resin (RT) onto the layer (3);

d$_2$) apply the impressions (M$_{10}$) of the first mold (M$_1$) created during the step c) to the thermoplastic resin (RT), at a temperature adapted to shape the thermoplastic resin (RT);

d$_3$) solidify the thermoplastic resin (RT) shaped during the step d$_2$), in such a manner as to obtain a lithography mask;

d$_4$) etch the layer (3) through the lithography mask obtained during the step d$_3$), in such a manner as to structure the layer (3).

5. Method according to Claim 2, in which the step d) comprises the steps:

D$_0$) provide a layer (3), intended to be structured, sandwiched between the substrate (1) and the oxide layer (10);

D$_1$) eliminate the series of first lithographic patterns (20) and the first neutralization layer (NL$_1$), the step D$_1$) being executed after the step c$_0$) such that the oxide layer (10) etched during the step c$_0$) forms a lithography mask;

D$_2$) etch the layer (3) through the lithography mask formed during the step D$_1$), in such a manner as to structure the layer (3);

D$_3$) remove the oxide layer (10).

6. Method according to Claim 5, in which the layer (3) provided during the step D$_0$) is formed from a material chosen so as to allow a selective etch of the oxide layer (10), the material preferably being TiN.

7. Method according to one of Claims 1 to 6, in which the first and second block copolymers (20, 21; 40, 41) are selected from amongst:

- polystyrene and polymethylmethacrylate, denoted PS-PMMA;
- polystyrene and polylactic acid, denoted PS-PLA;
- polystyrene and poly(ethylene oxide), denoted PS-PEO;
- polystyrene and polydimethylsiloxane, denoted PS-PDMS;
- polystyrene, polymethylmethacrylate, and poly(ethylene oxide), denoted PS-PMMA-PEO;
- polystyrene and poly(2-vinyl pyridine), denoted PS-P2VP.

8. Method for fabricating a recurrent neural network computer (C), comprising the successive steps:

a') provide a substrate (1') comprising a first electrode (E$_1$);

b'$_1$) deposit a thermoplastic resin (RT$_1$) onto the first electrode (E$_1$);

b'$_2$) apply the impressions (M$_{10}$) of the first mold (M$_1$), fabricated by the method according to one of Claims 1 to 9, onto the thermoplastic resin (RT$_1$), at a temperature adapted to shape the thermoplastic resin (RT$_1$);

b'$_3$) solidify the thermoplastic resin (RT$_1$) shaped during the step b'$_2$), in such a manner as to obtain a lithography mask;

b'$_4$) etch the first electrode (E$_1$) through the lithography mask obtained during the step b'$_3$), in such a manner as to structure the first electrode (E$_1$);

b'$_5$) remove the thermoplastic resin (RT$_1$);

c') form a memory layer (5), of the resistive memory type, on the first electrode (E$_1$) structured during the step b'$_4$);

d') form a second electrode (E$_2$) on the memory layer (5);

e'$_1$) deposit a thermoplastic resin (RT$_2$) on the

second electrode ($E_2$);

e'$_2$) apply the impressions ($M_{20}$) of the second mold ($M_2$), fabricated by the method according to one of Claims 1 to 9, onto the thermoplastic resin ($RT_2$), at a temperature adapted to shape the thermoplastic resin ($RT_2$);

e'$_3$) solidify the thermoplastic resin ($RT_2$) shaped during the step e'$_2$), in such a manner as to obtain a lithography mask;

e'$_4$) etch the second electrode ($E_2$) through the lithography mask obtained during the step e'$_3$), in such a manner as to structure the second electrode ($E_2$);

e'$_5$) remove the thermoplastic resin ($RT_2$).

9. Method according to Claim 8, in which the memory layer (5) formed during the step c') is formed from at least one material selected from amongst $HfO_2$, $Al_2O_3$, $SiO_2$, ZrO, an oxide of titanium, a chalcogenide, $Ta_2O_5$.

10. Method according to Claim 8 or 9, in which the first and second electrodes ($E_1$, $E_2$) are formed from at least one material selected from amongst Ti, TiN, Pt, Zr, Al, Hf, Ta, TaN, C, Cu, Ag.

11. Method according to one of Claims 8 to 10, comprising a step f') consisting in forming an encapsulation layer (6) on the second electrode ($E_2$) structured during the step e'$_4$), the step f') being executed after the step e'$_5$).

12. Method according to one of Claims 8 to 11, in which the first electrode (E1) structured during the step b'$_4$) has a pitch, denoted p, and in which the step c') is executed such that the memory layer (5) has a thickness, denoted E, verifying:

$$p/2 \leq E \leq p.$$

Fig. 1

Fig. 2a

Fig. 2b

Fig. 3

Fig. 4

$M_1$

Fig. 5a

$M_{10}$

Fig. 5b

RT
RT
RT
RT
3
1

Fig. 6

30
30
30
30
1

Fig. 7a

Fig. 7b

Fig. 8a

Fig. 8b

Fig. 9a

Fig. 9b

Fig. 10a

Fig. 10b

$E_1$

1'

101  100  101  Fig. 11a

$RT_1$  $RT_1$  $RT_1$  $RT_1$

$E_1$

1'

101  100  101  Fig. 11b

$E_1$  $E_1$  $E_1$  $E_1$

101  100  101  Fig. 11c

7  $E_1$  $E_1$  $E_1$  $E_1$

$E_1$

101  100  101  Fig. 11d

7  $E_1$  $E_1$  $E_1$  $E_1$

101  100  101  Fig. 11e

Fig. 11f

Fig. 11g

Fig. 11h

$E_1$

$1'$

$101$     $100$     $101$     **Fig. 12a**

$RT_1$     $RT_1$     $RT_1$     $RT_1$

$E_1$

$1'$

$101$     $100$     $101$     **Fig. 12b**

$E_1$     $E_1$     $E_1$     $E_1$

$101$     $100$     $101$     **Fig. 12c**

*Fig. 12d*

*Fig. 12e*

*Fig. 12f*

*Fig. 12g*

## RÉFÉRENCES CITÉES DANS LA DESCRIPTION

**Documents brevets cités dans la description**

- EP 3579151 A
- JP 2014066976 A
- US 2020012018 A
- FR 3074180 A

**Littérature non-brevet citée dans la description**

- **E.C. DEMIS et al.** Atomic switch networks - nanoarchitectonic design of a complex system for natural computing. *Nanotechnology,* 2015, vol. 26, 204003
- **WU W. et al.** One-kilobit cross-bar molecular memory circuits at 30-nm half-pitch fabricated by nanoimprint lithography. *Appl. Phys. A,* 2005, vol. 80, 1173-1178
- **KIM et al.** Directed assembly of high molecular weight block polymers : highly ordered line patterns of perpendicularly oriented lamellae with large periods. *ACS Nano,* 2013, vol. 7 (3), 1952-60